# FASCICULE DE BREVET EUROPEEN

(11) **EP 2 291 871 B1**
(45) Date de publication et mention de la délivrance du brevet: **16.09.2015**
(21) Numéro de dépôt: 09769210.7
(22) Date de dépôt: 22.06.2009
(51) Int. Cl.: H01L 35/30, F28D 7/00, F28F 1/32

(54) **DISPOSITIF DE GENERATION D'ENERGIE ELECTRIQUE, FAISCEAU D'ECHANGE DE CHALEUR COMPRENANT UN TEL DISPOSITIF ET ECHANGEUR DE CHALEUR COMPRENANT UN TEL FAISCEAU**
VORRICHTUNG ZUR ERZEUGUNG VON STROM, WÄRMETAUSCHERBÜNDEL MIT DERARTIGER VORRICHTUNG UND WÄRMETAUSCHER MIT DERARTIGEM BÜNDEL
DEVICE FOR GENERATING ELECTRICAL ENERGY, HEAT EXCHANGE BUNDLE COMPRISING SUCH A DEVICE, AND HEAT EXCHANGER COMPRISING SUCH A BUNDLE

(30) Priorité: 24.06.2008 FR 0803518
(43) Date de publication de la demande: 09.03.2011
(73) Titulaire: VALEO SYSTEMES THERMIQUES, 78320 Le Mesnil Saint-Denis (FR)
(72) Inventeur: SIMONIN, Michel, F-78960 Voisins-le-bretonneux (FR)
(74) Mandataire: Rolland, Jean-Christophe
(86) Numéro de dépôt international: PCT/EP2009/057729
(87) Numéro de publication internationale: WO 2009/156361

(56) Documents cités:
- EP-A- 0 055 175
- WO-A-2005/020422
- FR-A- 2 550 324
- GB-A- 2 386 573
- JP-A- 2000 356 409
- US-A1- 2005 087 222
- US-A1- 2006 157 102

## Description

L'invention concerne le domaine de la thermoélectricité et, plus particulièrement, la conversion de l'énergie calorifique (chaleur) en énergie électrique (électricité).

Un des buts de l'invention est de limiter l'émission de particules polluantes par un véhicule automobile en limitant sa consommation d'énergie tirée du carburant et en utilisant, comme substitut partiel, de l'énergie électrique générée par des éléments thermoélectriques.

On connaît des éléments thermoélectriques, ayant au moins deux faces, qui ont la particularité de générer un courant électrique entre les deux faces de l'élément lorsque les faces sont à des températures différentes. Autrement dit, si on chauffe une face de l'élément thermoélectrique tout en refroidissant son autre face, il se crée un déplacement d'électrons entre les faces chaude et froide de l'élément thermoélectrique, le déplacement d'électrons formant un courant électrique. Plus la différence de températures entre les faces de l'élément thermoélectrique est importante, plus grande est l'énergie électrique générée par l'élément. La génération d'un courant électrique par un élément thermoélectrique soumis à une différence de températures (gradient thermique) est connue sous la désignation « effet Seebeck ».

Les éléments thermoélectriques sont utilisés principalement dans la fabrication des ailes des satellites spatiaux. Une aile de satellite comprend, de manière classique, une première face chaude qui est tournée vers le soleil et une seconde face froide, opposée à la première, qui est tournée vers le vide sidéral. Ainsi, en disposant un élément thermoélectrique entre les deux faces d'une aile d'un satellite spatial, on peut générer un courant électrique pour alimenter différents équipements électriques du satellite.

Un des inconvénients des éléments thermoélectriques consiste dans le fait qu'ils possèdent un rendement très faible de conversion de l'énergie calorifique en énergie électrique, ce rendement étant traditionnellement de l'ordre de 1 à 10%. Aussi, il est nécessaire de fournir une grande quantité de chaleur à l'élément thermoélectrique pour générer un courant électrique suffisant permettant d'alimenter au moins un équipement électrique.

Afin de limiter les pertes thermiques et augmenter le rendement de conversion, on connaît des dispositifs de génération d'énergie électrique dans lesquels les faces d'un élément thermoélectrique, ayant au moins deux faces, sont directement et respectivement en contact avec une source de chaleur froide et une source de chaleur chaude. Lors du contact direct entre une source de chaleur (froide ou chaude) et une face de l'élément thermoélectrique, l'énergie calorifique provenant de la source de chaleur est transmise avec peu de pertes thermiques à l'élément thermoélectrique. Au contraire, du point de vue électrique, du fait du contact direct entre la source de chaleur (froide ou chaude) et la face de l'élément thermoélectrique, l'énergie électrique a tendance à se disperser dans la source de chaleur sans pouvoir être exploitée.

A titre d'exemple, lorsque les sources de chaleur chaude et froide se présentent respectivement sous la forme de fluides chaud et froid circulant dans des conduites de fluide métalliques, des fuites électriques apparaissent aussi bien dans les conduites de fluide métalliques que dans les fluides eux-mêmes. En raison des pertes électriques, la quantité d'énergie électrique exploitable est très faible.

Le courant électrique qui se crée entre les deux faces de l'élément thermoélectrique par effet Seebeck est traditionnellement acheminé hors du dispositif de génération d'énergie électrique par des câbles électriques reliés aux faces dudit élément thermoélectrique. Cependant, de tels câbles sont complexes à connecter à l'élément thermoélectrique lorsque ce dernier est « pris en sandwich » (intercalé) entre deux conduites de fluide métalliques. En outre, la présence de câbles d'acheminement du courant électrique augmente le risque de court-circuit au sein du dispositif de génération d'énergie électrique.

US 2005/087222 A1 (MULLER-WERTH BERNHARD [DE]) 28 avril 2005 (2005-04-28) décrit un dispositif dans lequel des éléments thermo électriques p, n sont en contact avec des ailettes chaudes 6 et froides 6'. Les ailettes chaudes 6 sont en communication avec des caloducs 8 et les ailettes froides 6' sont en communication avec des caloducs 8'. Les caloducs 8, 8' sont à leur tour en relation avec des réservoirs de fluide, un réservoir 11 de fluide chaud pour les caloducs 8 et un réservoir 11' de fluide froid pour les caloducs 8'. Autrement dit, les caloducs 8, 8' sont interposés entre les réservoirs 11, 11' et les ailettes 6, 6'. US 2006/157102 A1 (NAKAJIMA KENICHIRO [JP] ET AL) 20 juillet 2006 (2006-07-20) décrit un dispositif dans lequel des plaques 9A, 9B sont intercalées entre les éléments thermo électriques 25 et des conduits de circulations de fluides 15, 21. Elles sont parallèles aux conduits et ne sont donc pas traversées par les tubes.

Afin d'éliminer ces inconvénients, l'invention concerne un dispositif de génération d'énergie électrique par conversion d'énergie calorifique en énergie électrique, comprenant :
- une première conduite de circulation d'un fluide chaud, le fluide chaud ayant une température T 1 ;- une deuxième conduite de circulation d'un fluide froid, le fluide froid ayant une température T2 qui est inférieure à la température T du fluide chaud ; et- un élément thermoélectrique, ayant au moins deux faces, agencé pour générer un courant électrique entre ses faces lorsqu'elles sont à des températures différentes,- des moyens de conduction thermique se présentant sous la forme d'un premier intercalaire chaud de conduction thermique, par exemple une plaque métallique, relié à la conduite de fluide chaud, et d'un deuxième intercalaire froid de conduction thermique, par exemple une plaque métallique, relié à la conduite de fluide froid, les intercalaires chaud et froid étant reliés à deux faces différentes de l'élément thermoélectrique et chaque conduite de fluide traversant les deux intercalaires.

Les moyens de conduction thermique du dispositif de génération d'énergie électrique permettent avantageusement de favoriser la transmission de chaleur entre l'élément thermoélectrique et les conduites de fluides, permettant ainsi de fournir une grande quantité d'énergie calorifique et générer une grande quantité d'énergie électrique par effet Seebeck.

En outre, les moyens de conduction thermique forment un intermédiaire pour la conduction électrique entre les conduites de fluides et l'élément thermoélectrique, limitant ainsi les pertes électriques depuis l'élément thermoélectrique vers les conduites de fluides et les fluides eux-mêmes.

De préférence, les moyens de conduction thermique sont agencés pour former, avec l'élément thermoélectrique, une pile électrique dont lesdits moyens de conduction thermique sont les bornes.

Ainsi, on peut prélever le courant électrique généré par l'élément thermoélectrique par les moyens de conduction thermique, évitant ainsi de recourir à des câbles électriques supplémentaires dédiés au transport du courant électrique qui sont encombrants et susceptibles de créer des courts-circuits.

De préférence, les moyens de conduction thermique sont agencés pour isoler électriquement les conduites de fluide de l'élément thermoélectrique, permettant avantageusement de limiter encore mieux les pertes électriques dans le dispositif. Les moyens de conduction thermique remplissent ainsi avantageusement une double fonction (conduction thermique et isolation électrique), ce qui permet d'augmenter le rendement de conversion de l'énergie calorifique tout en conservant un dispositif compact.

De préférence encore, les moyens de conduction thermique sont agencés pour assurer le maintien en position des conduites de fluides. Les moyens de conduction thermique remplissent ainsi une fonction supplémentaire de maintien, ce qui permet de former des dispositifs de génération d'énergie très compacts.

Selon l'invention, les moyens de conduction thermique se présentent sous la forme d'un premier intercalaire chaud de conduction thermique, par exemple une plaque métallique, relié à la conduite de fluide chaud, et d'un deuxième intercalaire froid de conduction thermique, par exemple une plaque métallique, relié à la conduite de fluide froid, les intercalaires chaud et froid étant reliés à deux faces différentes de l'élément thermoélectrique.

De préférence, chaque intercalaire comporte un orifice d'isolation thermique et un orifice de conduction thermique. Selon l'invention, chaque conduite de fluide traversant les deux intercalaires.

L'invention concerne également un faisceau d'échange de chaleur d'un échangeur de chaleur de véhicule automobile destiné à refroidir un fluide à refroidir, ledit fluide à refroidir circulant dans au moins une conduite de fluide à refroidir, ledit fluide à refroidir étant refroidi par un fluide caloporteur, de température inférieure à celle du fluide à refroidir, ledit fluide caloporteur circulant dans au moins une conduite de fluide caloporteur, ledit faisceau comprenant un dispositif de génération d'énergie électrique tel que décrit précédemment, la conduite de fluide à refroidir formant la conduite de fluide chaud et la conduite de fluide caloporteur formant la conduite de fluide froid.

L'intégration, dans un faisceau d'échange de chaleur, d'un dispositif de génération d'énergie permet de récupérer l'énergie des gaz chauds du moteur, qui est inutilisée, et de la convertir en énergie électrique pouvant alimenter des équipements électriques du véhicule.

L'intégration d'un élément thermoélectrique entre les conduites de circulation des fluides (gaz et/ou liquide) du faisceau d'échange de chaleur permet de manière avantageuse de générer de l'énergie sans modifier l'agencement ni augmenter le volume de l'échangeur de chaleur.

De préférence, le faisceau comprenant une pluralité de conduites de fluide à refroidir et une pluralité de conduites de fluide caloporteur, dans lequel les conduites de fluide à refroidir sont alternées spatialement avec les conduites de fluide caloporteur.

De préférence encore, la pluralité de conduites de fluide caloporteur est maintenue en position par une pluralité d'intercalaires froids et la pluralité de conduites de fluide à refroidir est maintenue en position par une pluralité d'intercalaires chauds, les intercalaires froids étant alternés spatialement avec les intercalaires chauds.

De préférence, les conduites de fluide caloporteur, et les conduites de fluide à refroidir sont parallèles et coplanaires et forment, avec les intercalaires chauds et froids, une rangée du faisceau d'échange de chaleur.

De préférence toujours, des éléments thermoélectriques sont disposés entre les intercalaires froids et les intercalaires chauds, chaque élément thermoélectrique ayant une face en contact avec un intercalaire chaud et une autre face en contact avec un intercalaire froid.

De préférence, des jonctions thermoélectriques sont disposées entre deux intercalaires froids successifs, une jonction thermoélectrique comprenant deux éléments thermoélectriques montés en sens inverses et séparés par un intercalaire chaud.

Les jonctions thermoélectriques permettent d'augmenter la quantité d'énergie électrique générée sans modifier la configuration de l'échangeur de chaleur.

Selon une autre caractéristique de l'invention, les intercalaires froids sont connectés électriquement en série les uns avec les autres.

On peut ainsi récupérer, de manière avantageuse, la tension électrique générée par l'ensemble des éléments thermoélectriques d'une rangée du faisceau d'échange de chaleur.

De préférence encore, le faisceau d'échange de chaleur comprend une pluralité de rangées. Les conduites de fluide caloporteur et les conduites de fluide à refroidir, qui sont parallèles, coplanaires et maintenues par les intercalaires chauds et froids, forment une rangée du faisceau d'échange de chaleur.

De préférence toujours, les rangées du faisceau d'échange de chaleur sont connectées électriquement en série les unes avec les autres.

On peut ainsi récupérer, de manière avantageuse, la tension électrique générée par l'ensemble des rangées du faisceau d'échange de chaleur.

Selon une forme de réalisation avantageuse, le fluide à refroidir est un flux de gaz d'échappement d'un moteur thermique à combustion interne du véhicule automobile.

Cela permet avantageusement de diminuer la chaleur des gaz d'échappement du véhicule tout en générant de l'électricité.

L'invention concerne également un échangeur de chaleur comprenant un faisceau d'échange de chaleur tel que décrit précédemment.

L'invention sera mieux comprise à l'aide du dessin annexé sur lequel :
- la figure 1 représente schématiquement un échangeur de chaleur selon l'invention ;
- la figure 2 représente schématiquement un empilement de tubes du faisceau d'échange de chaleur de l'échangeur de chaleur de la figure 1 ;
- la figure 3 représente une vue schématique en perspective de la liaison de deux tubes d'un faisceau d'échange de chaleur avec deux intercalaires de conduction thermique et un élément thermoélectrique ;
- la figure 4 représente une vue en éclaté de la figure 3 ;
- la figure 5 représente une vue de face d'un intercalaire de la figure 3 ;
- la figure 6 représente une vue schématique de dessus de la liaison de deux tubes d'un faisceau d'échange de chaleur avec trois intercalaires de conduction thermique et deux éléments thermoélectriques ;
- la figure 7 représente une vue schématique de dessus d'un faisceau d'échange de chaleur selon l'invention, les intercalaires de conduction thermique étant représentés en vue de face;
- la figure 8a représente une rangée d'un faisceau d'échange de chaleur avec les intercalaires de conduction thermique montés électriquement en parallèle ; et
- la figure 8b représente une rangée d'un faisceau d'échange de chaleur avec les intercalaires de conduction thermique montés électriquement en série.

A titre d'exemple, l'invention va être présentée en relation avec un échangeur de chaleur de véhicule automobile à génération d'énergie électrique. Cependant, il va de soi que cette invention s'applique à tout dispositif de génération d'énergie électrique comportant deux sources de chaleur de températures différentes.

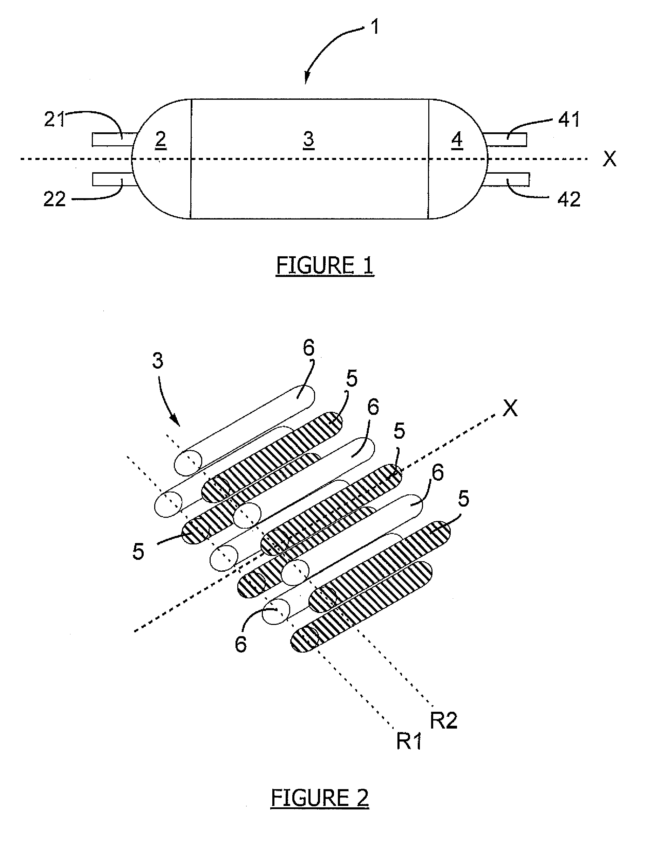

De manière classique, un échangeur de chaleur 1, ou refroidisseur, pour véhicule automobile est monté dans une ligne de refroidissement de gaz du véhicule. En référence aux figures 1 et 2, l'échangeur de chaleur 1 comprend un faisceau d'échange de chaleur 3 comportant des tubes 5 ou conduites de circulation d'un fluide à refroidir, ici des gaz chauds de température T1, désignés par la suite tubes de gaz chauds 5, et des tubes 6 ou conduites de circulation d'un fluide caloporteur de température T2 inférieure à la température T1 des gaz chauds, désignés par la suite tubes de refroidissement 6. Le faisceau d'échange de chaleur 3 s'étend selon un axe X, désigné par la suite axe X de l'échangeur de chaleur 1.

Les tubes de gaz chauds 5 et les tubes de refroidissement 6 forment des conduites de fluides de températures différentes.

Les gaz chauds et le fluide caloporteur sont introduits dans le faisceau de tubes de l'échangeur de chaleur 1 par l'intermédiaire d'une boîte collectrice d'entrée 2 placée à l'entrée du faisceau de tubes 3 de l'échangeur de chaleur 1. Une boîte collectrice de sortie 4, du même type que celle montée à l'entrée de l'échangeur de chaleur 1, est installée à la sortie de l'échangeur 1 pour recevoir les fluides ayant traversé les tubes de gaz chauds 5 et les tubes de refroidissement 6. La boîte collectrice d'entrée 2 comprend ici une tubulure 21 d'entrée des gaz chauds et une tubulure d'entrée 22 du fluide caloporteur, la boîte collectrice de sortie 4 comprenant, de manière similaire, deux tubulures de sortie permettant respectivement d'évacuer les gaz chauds et le fluide caloporteur 41, 42.

Les tubes de gaz chauds 5 et les tubes de refroidissement 6 du faisceau d'échange de chaleur 3 sont maintenus à leurs extrémités par des plaques collectrices (ou collecteurs) logées dans les boîtes collectrices d'entrée 2 et de sortie 4, les plaques collectrices, non représentées, comportant des orifices pour le maintien des tubes de gaz chauds 5 et des tubes de refroidissement 6.

En référence maintenant à la figure 2, les tubes de gaz chauds 5 sont disposés parallèlement sur une ou plusieurs rangées (R1, R2) dans le faisceau d'échange de chaleur 3, ces tubes 5 étant destinés à la circulation de gaz chauds qui sont, dans cet exemple, des gaz d'échappement du moteur thermique à combustion interne du véhicule. Ces gaz d'échappement, qui ont une température dépassant les 200°C, sont destinés à être refroidis par l'échangeur de chaleur 1 par circulation du fluide caloporteur dont la température est inférieure à celle des gaz d'échappement.

En référence à la figure 2, le faisceau d'échange de chaleur 3 comprend également des tubes de refroidissement 6 qui sont disposés entre les tubes de gaz chauds 5 pour chaque rangée de tubes (R1, R2) du faisceau échange de chaleur 1, les tubes de refroidissement 6 étant destinés à la circulation d'un fluide caloporteur, ici de l'eau additionnée à du glycol dont la température T2 avoisine 60°C,

Autrement dit, une rangée de tubes d'échange de chaleur (R1, R2) se présente sous la forme d'un ensemble de tubes de refroidissement 6 et de tubes de gaz chauds 5, tous disposés parallèlement dans un même plan à égale distance les uns des autres. Les tubes de refroidissement 6 sont alternés avec les tubes de gaz chauds 5 afin de permettre un échange de chaleur depuis les gaz d'échappement chauds (T1>200°C) vers le fluide caloporteur (T2=60°C). En référence à la figure 2, les tubes de refroidissement 6 et les tubes de gaz chauds 5 sont disposés, à titre d'exemple, selon deux rangées (R1, R2).

Dans cet exemple, les fluides chauds et froids circulent dans des tubes métalliques rectilignes 5, 6 s'étendant d'une extrémité à l'autre du faisceau d'échange de chaleur 3 selon l'axe X de l'échangeur de chaleur 1, les tubes métalliques 5, 6 du faisceau d'échange de chaleur 3 étant réalisés en un métal tel que de l'aluminium, du cuivre ou de l'inox. Le diamètre des tubes 5, 6 pourra être différent en fonction des fluides y circulant.

Outre sa fonction de refroidissement, l'échangeur de chaleur 1 comprend une fonction secondaire consistant à générer de l'énergie électrique à partir de l'énergie calorifique des gaz d'échappement du véhicule. Un tel échangeur de chaleur 1 permet d'alimenter des équipements électriques du véhicule (phares, système de climatisation, etc.) en limitant la consommation en carburant du véhicule et, par voie de conséquence, le rejet dans l'atmosphère de particules polluantes telles que du dioxyde de carbone (CO₂).

Afin de générer de l'énergie électrique, l'échangeur de chaleur 1 comprend des éléments thermoélectriques 10, ayant au moins deux faces 10A, 10B. Un élément thermoélectrique 10 permet de générer un courant électrique entre ses deux faces 10A, 10B lorsqu'elles sont à des températures différentes. Autrement dit, si on chauffe une face 10A de l'élément thermoélectrique 10 tout en refroidissant son autre face 10B, il se crée un déplacement d'électrons entre les faces chaude 10A et froide 10B de l'élément thermoélectrique 10, le déplacement d'électrons formant un courant électrique. Plus la différence de températures (T1-T2) entre les faces 10A, 10B de l'élément thermoélectrique 10 est importante, plus grande est l'énergie électrique générée par l'élément thermoélectrique 10.

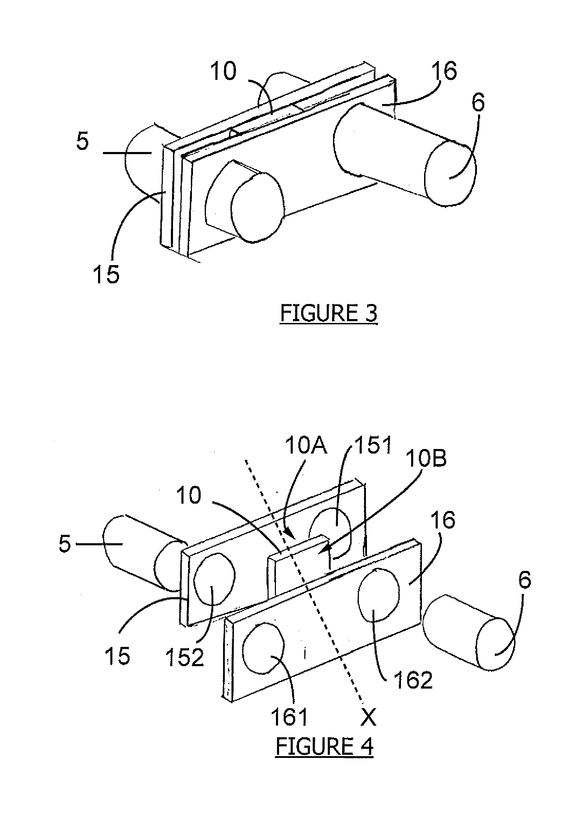

En référence à la figure 3, un élément thermoélectrique 10 est disposé entre deux intercalaires de conduction thermique 15, 16, qui sont respectivement en contact avec les deux faces 10A, 10B de l'élément thermoélectrique 10.

A titre d'exemple, en référence aux figures 3 et 4, un premier intercalaire de conduction thermique 15, désigné par la suite intercalaire chaud 15, relie thermiquement un tube de gaz chauds 5 à une première face 10A de l'élément thermoélectrique 10, dite face chaude 10A de l'élément thermoélectrique 10. De manière semblable, un deuxième intercalaire de conduction thermique 16, désigné par la suite intercalaire froid 16, relie thermiquement un tube de refroidissement 6 à une deuxième face 10B de l'élément thermoélectrique 10, dite face froide 10B de l'élément thermoélectrique 10. Ici, les intercalaires chauds 15 et les intercalaires froids 16 et sont traversés à la fois par les tubes de refroidissement 5 et par les tubes des gaz chauds 6.

En référence à la figure 4, représentant le positionnement de l'élément thermoélectrique 10 par rapport aux intercalaires chaud 15 et froid 16, l'élément thermoélectrique 10 se présente sous la forme d'un parallélépipède unique ou d'un ensemble de plusieurs parallélépipèdes indépendants formant un carré de côté sensiblement égal à 10 mm et d'épaisseur sensiblement égale à 5 mm. L'élément thermoélectrique 10 est connu en soi et comporte, dans cet exemple, du Bismuth et du Tellurium (Bi₂Te₃). Il va de soi que l'élément thermoélectrique pourrait également comporter du TAGS (Tellurium, Arsenic, Germanium, Silicium), du PbTe (Plomb-Tellurium) ou d'autres composants assemblés en couches parallèles.

Un élément thermoélectrique 10 possède une orientation propre qui est déterminée par l'agencement des couches de matériaux qu'il comporte. Ainsi, à titre d'exemple, pour un élément thermoélectrique 10 comportant une couche de Bi₂Te₃ et une couche de PbTe, la face froide 10B de l'élément thermoélectrique 10 correspond à la couche de Bi₂Te₃, tandis que sa face chaude 10A correspond à la couche de PbTe. Ainsi, lorsque l'on monte un élément thermoélectrique 10 entre deux intercalaires 15, 16, il faut veiller à l'orientation de l'élément thermoélectrique 10 afin que ses faces chaude 10A et froide 10B soient respectivement en contact avec les intercalaires chaud 15 et froid 16.

Les intercalaires de conduction thermique 15, 16 s'étendent orthogonalement aux tubes 5, 6 du faisceau d'échange de chaleur 3 et parallèlement les uns aux autres, les intercalaires chauds 15 étant alternés avec les intercalaires froids 16. Les intercalaires de conduction thermique 15, 16, chauds ou froids, se présentent sous la forme de bandes rectilignes d'épaisseur sensiblement égal à 1 mm. Les bandes sont métalliques et peuvent comporter de l'aluminium, du cuivre, de l'inox ou un autre matériau métallique conducteur de chaleur.

Chaque intercalaire de conduction thermique, chaud 15 ou froid 16, comporte, dans sa longueur, des orifices 151, 152, 161, 162 agencés pour permettre le passage des tubes métalliques de gaz chauds 5 et des tubes métalliques de refroidissement 6, chaque intercalaire de conduction thermique 15, 16 comporte deux types d'orifices : des orifices de conduction thermique 152, 162 et des orifices d'isolation thermique 151, 161 qui sont alternés dans l'intercalaire 15, 16 selon sa longueur.

En référence aux figures 3, 4 et 5, un tube de refroidissement 6 et un tube de gaz chauds 5 du faisceau d'échange de chaleur 3 sont reliés à un élément thermoélectrique 10 par deux intercalaires de conduction thermique 15, 16.

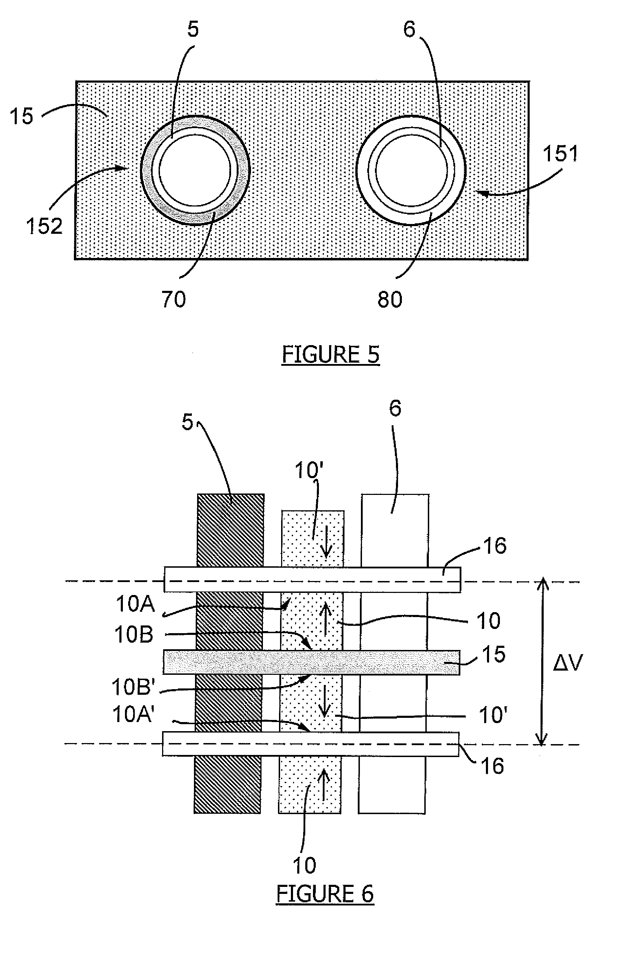

En référence plus particulièrement à la figure 5, l'intercalaire chaud 15 comporte un orifice de conduction thermique 152 dans lequel est maintenu en position le tube de gaz chauds 5, des moyens d'isolation électrique 70 étant ici disposés entre la surface externe du tube de gaz chauds 5 et la surface intérieure de l'orifice de conduction 152 de l'intercalaire chaud 15. Dans cet exemple, le tube de gaz chauds 5 est recouvert d'une peinture ou vernis d'isolation électrique 70 évitant la conduction d'un courant électrique entre l'intercalaire chaud 15 et le tube métallique de gaz chauds 5. D'autres moyens d'isolation électrique 70 pourraient également convenir, tels qu'une bague en élastomère qui serait disposée entre le tube de gaz chaud 5 et l'orifice de conduction 152 de l'intercalaire chaud 15, l'important étant que les moyens d'isolation électrique 70 ne perturbent pas la conduction thermique.

L'intercalaire chaud 15 comporte aussi un orifice d'isolation thermique 151 dans lequel est introduit le tube de refroidissement 6, des moyens d'isolations thermiques et électriques 80 étant ici disposés entre la surface externe du tube de refroidissement 6 et la surface intérieure de l'orifice d'isolation 151 de l'intercalaire chaud 15. Dans cet exemple, le tube froid 6 est introduit sans contact avec l'orifice d'isolation 151, de l'air 80 isolant l'intercalaire chaud 15 et le tube métallique de refroidissement 6. D'autres moyens d'isolations thermiques et électriques 80 pourraient également convenir tel que des bagues en céramique afin d'éviter la conduction de l'énergie thermique et électrique entre l'intercalaire chaud 15 et le tube de refroidissement 6, des bagues en céramique 80 permettant en outre d'assurer le maintien en position des tubes de refroidissement 6 par les intercalaires chauds 15.

De manière similaire, l'intercalaire froid 16 comporte un orifice d'isolation 161 dans lequel est maintenu en position le tube de gaz chauds 5, des moyens d'isolations thermiques et électriques 80, similaires à ceux précédemment décrits, étant également disposés entre le tube de gaz chauds 5 et l'orifice d'isolation 161 de l'intercalaire froid 16. De même, l'intercalaire froid 16 comporte également un orifice de conduction 162 dans lequel est maintenu en position le tube de refroidissement 6, des moyens d'isolation électrique 70, similaires à ceux précédemment décrits, étant également disposés entre la surface externe du tube de refroidissement 6 et la surface intérieure de l'orifice de conduction 162 de l'intercalaire froid 16.

En référence à la figure 3, le tube de gaz chauds 5 est introduit successivement dans l'orifice de maintien et de conduction thermique 152 de l'intercalaire chaud 15 et dans l'orifice d'isolation thermique 161 de l'intercalaire froid 16. De même, le tube de refroidissement 6 est introduit successivement dans l'orifice d'isolation thermique 151 de l'intercalaire chaud 15 et dans l'orifice de maintien et de conduction thermique 162 de l'intercalaire froid 16.

Le maintien de l'ensemble tubes gaz chauds 5, tubes de refroidissement 6, intercalaires chaud 15 et intercalaires froids 16 pourra être réalisé, par exemple, par sertissage au moyen d'un outil introduit à l'intérieur des tubes de manière à déformer leurs parois et les appliquer à force contre les orifices 151, 152, 161 et 162 ménagés dans les intercalaires 15 et 16. Ce type d'assemblage est dit de type mécanique, Comme déjà indiqué plus haut, les extrémités des tubes débouchent dans des boites collectrices au niveau d'orifices prévues dans une plaque collectrice de ladite boite. Selon le mode d'assemblage mécanique, un joint pourra être prévu entre lesdits tubes et ladite plaque au niveau desdits orifices.

Le maintien de l'ensemble tubes gaz chauds 5, tubes de refroidissement 6, intercalaires chaud 15 et intercalaires froids 16 pourra aussi être réalisé par gonflage mécanique des tubes 5, 6 de manière à les précontraindre sur les intercalaires 15, 16.

L'élément thermoélectrique 10 est, pour sa part, maintenu entre les intercalaires chauds 15 et froids 16, les faces 10A, 10B de l'élément thermoélectrique 10 étant en contact avec les portions de surface des intercalaires de conduction comprises entre un orifice de maintien et de conduction 152, 162 et un orifice d'isolation 151, 161.

Après avoir décrit la structure des moyens de l'invention, son fonctionnement et sa mise en oeuvre vont maintenant être abordés.

Le fonctionnement de l'invention va être tout d'abord décrit d'un point de vue élémentaire, pour un unique élément thermoélectrique, puis pour deux éléments thermoélectriques couplés et enfin généralisé à l'ensemble du faisceau d'échange de chaleur de l'échangeur de chaleur.

### Génération d'énergie électrique par un unique élément thermoélectrique

En référence à la figure 3, le tube métallique de conduction de gaz chauds 5 est relié thermiquement à l'intercalaire chaud 15 dont la température est sensiblement égale à la température des gaz d'échappement circulant dans ledit tube de gaz chauds 5. De même, le tube métallique de conduction de fluide caloporteur 6 est relié thermiquement à l'intercalaire froid 16 dont la température est sensiblement égale à la température du fluide caloporteur circulant dans ledit tube de refroidissement 6.

Les faces chaude 10A et froide 10B de l'élément thermoélectrique 10 sont respectivement en contact surfacique avec les intercalaires chaud 15 et froid 16, un gradient thermique se formant entre les faces 10A, 10B de l'élément thermoélectrique 10 entraînant la formation d'un courant électrique entre les dites faces 10A, 10B par effet Seebeck. Le courant électrique circule dans les intercalaires chaud 15 et froid 16 pour être ensuite récupéré à leurs extrémités afin d'être exploité. La récupération du courant électrique sera détaillée par la suite.

### Génération d'énergie électrique par deux éléments thermoélectriques couplés

Bien que l'effet Seebeck puisse survenir pour un unique élément thermoélectrique 10, on peut renforcer cet effet et ainsi augmenter l'énergie électrique générée, en couplant deux éléments thermoélectriques 10 et ainsi former une jonction thermoélectrique génératrice de courant.

Une jonction thermoélectrique comprend un premier élément thermoélectrique 10, dit de type p, et un second élément thermoélectrique 10', dit de type n. Ces deux éléments thermoélectriques 10, 10' sont reliés en série par un matériau conducteur dont le pouvoir thermoélectrique est supposé nul.

A titre d'exemple, en référence à la figure 6, une jonction thermoélectrique est ménagée dans un empilement comprenant successivement un premier intercalaire froid 16, un premier élément thermoélectrique 10 (formant la liaison P), un intercalaire chaud 15, un deuxième élément thermoélectrique 10'(formant la liaison N) et un deuxième intercalaire froid 16'. Les éléments thermoélectriques 10, 10' sont ici montés dans des sens opposés. L'orientation de chaque élément thermoélectrique 10, 10' est représenté par des flèches sur la figure 6, les flèches pointant vers la face froide de l'élément thermoélectrique 10, 10'. En effet, comme indiqué précédemment, un élément thermoélectrique 10, 10' possède une orientation déterminée par l'agencement des couches de matériaux qu'il comporte. Dans cet exemple, les éléments thermoélectriques 10, 10' sont orientés dans des sens opposés afin que leurs faces chaudes 10A, 10A' soient en contact avec l'intercalaire chaud 15 et que leurs faces froides 10B, 10B' soient respectivement en contact avec les premier et deuxième intercalaires froids 16, 16'.

Du fait de l'effet Seebeck, il se forme dans chacun des éléments thermoélectriques 10, 10' un courant électrique élémentaire. Du fait de l'orientation des éléments thermoélectriques 10, 10' en sens opposés, un courant électrique se forme dont l'intensité est plus importante que celle d'un courant élémentaire issu d'un élément thermoélectrique unique 10 ou 10'.

Ainsi, un courant électrique se forme entre les premier et deuxième intercalaires froids 16, 16', ce courant électrique global pouvant être récupéré pour alimenter des équipements électriques.

### Génération d'énergie électrique dans une rangée de tubes d'un faisceau d'échange de chaleur

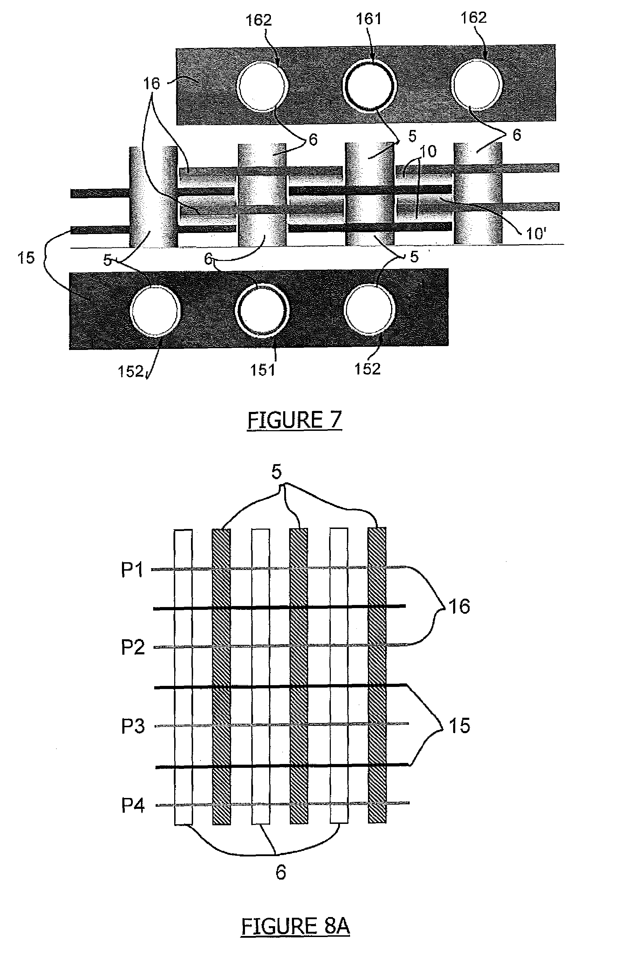

En référence à la figure 8A, dans une rangée de tubes d'un faisceau d'échange de chaleur, les intercalaires chauds 15 et froids 16 sont alternés pour maintenir les tubes métalliques 5, 6 parallèles et coplanaires.

En référence à la figure 7 représentant une vue rapprochée de la rangée du faisceau d'échange de chaleur 3, des jonctions thermoélectriques sont ménagées entre deux intercalaires froids successifs 16, et ce, entre chaque tube de gaz chauds 5 et chaque tube de refroidissement 6.

En référence à la figure 6, les courants électriques générés par chacune des trois jonctions thermoélectriques, disposées entre les deux intercalaires froids 16, s'additionnent pour engendrer une différence de potentiel électrique (ΔV) de forte amplitude entre les intercalaires froids 16. Autrement dit, plus le nombre de tubes et d'intercalaires est élevé, plus la quantité d'énergie électrique générée est importante.

Toujours en référence à la figure 8A, les intercalaires froids 16 d'une même rangée de tubes d'un faisceau d'échange de chaleur 3 sont montés électriquement en parallèle. Un montage en parallèle des intercalaires froids 16 permet avantageusement de récupérer un courant électrique avec une intensité électrique importante pour alimenter des équipements électriques du véhicule. Les extrémités (PI, P2, P3, P4) des intercalaires froids 16 forment des bornes électriques agencées pour permettre la récupération du courant généré par la rangée de tubes du faisceau d'échange de chaleur 3.

Dans ce mode de réalisation, les éléments thermoélectriques intercalés entre un intercalaire chaud et un intercalaire froid adjacents sont de même type (autrement dit, ils sont tous de type p ou de type n). Autrement dit, dans ce mode de réalisation, on alterne, entre un tube chaud et un tube froid adjacents, des éléments thermoélectriques de type différents (p puis, n, puis p, puis n), chaque élément thermoélectrique étant séparé de son voisin par un intercalaire.

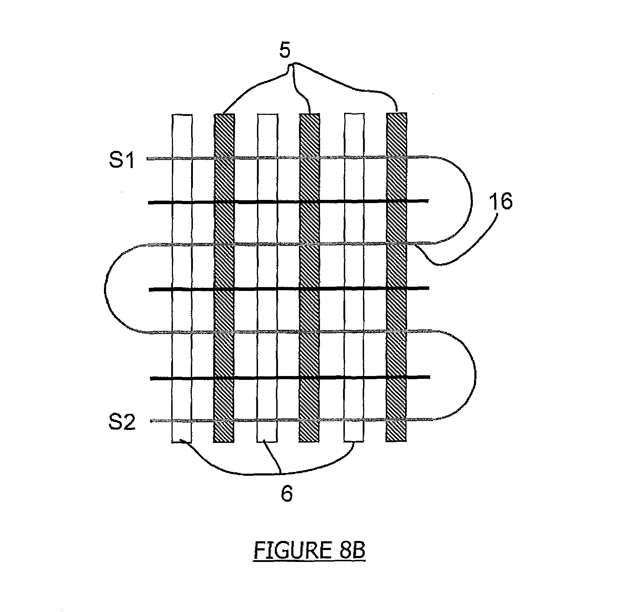

Selon une autre forme de réalisation, en référence à la figure 8B, les intercalaires froids 16 d'une même rangée de tubes d'un faisceau d'échange de chaleur 3 sont montés électriquement en série. Autrement dit, pour un intercalaire froid donné, ses extrémités sont reliées respectivement aux intercalaires froids de sa rangée qui sont les plus proches de lui, i.e. les intercalaires montés au dessus et en dessous dudit intercalaire froid donné comme représenté sur la figure 8B. Un montage en série des intercalaires froids 16 permet avantageusement de récupérer une tension électrique important pour alimenter des équipements électriques du véhicule. En référence à la figure 8B, les quatre intercalaires froids 16 du faisceau d'échange de chaleur 3 sont ici reliés en série, un intercalaire froid placé sensiblement au milieu de la rangée ayant une extrémité connectée à l'intercalaire froid placé au dessus de lui et une extrémité connectée à l'intercalaire froid placé en dessous de lui.

Toujours en référence à la figure 8B, les intercalaires froids 16 disposés aux extrémités de la rangée du faisceau d'échange de chaleur 3 présentent chacun une extrémité libre S1, S2, qui n'est pas connectée aux autres intercalaires froids 16 de la rangée. Ces extrémités libres S1, S2 forment des bornes électriques S1, S2 par lesquelles l'énergie électrique générée par la rangée du faisceau d'échange de chaleur 3 peut être prélevée en vue de son exploitation. Par la suite, on désignera par rangée « série » du faisceau d'échange de chaleur : des tube de gaz chauds 5 et des tubes refroidissement 6, qui sont parallèles, coplanaires et maintenus par des intercalaires chauds et froids 15, 16, et dont les intercalaires froids sont connectés en série.

### Génération d'énergie électrique dans un faisceau d'échange de chaleur

En outre, dans une forme de réalisation non représentée, un faisceau d'échange de chaleur 3, comprend des rangées du type « série » qui sont reliées électriquement en série les unes avec les autres.

Pour un faisceau d'échange de chaleur 3 comprenant un empilement vertical de plusieurs rangées du type « série », chaque rangée comporte deux bornes libres S1, S2 comme détaillé précédemment. Pour une rangée Rₙ de cet empilement, sa première borne libre Sₙ1 est connectée électriquement à une borne libre (Sₙ₊₁1, Sₙ₊₁2) de la rangée Rₙ₊₁ de l'empilement montée au dessus de ladite rangée Rₙ. De même, la deuxième borne libre Sₙ2 de ladite rangée Rₙ est connectée électriquement à une borne libre (Sₙ₋₁1, Sₙ₋₁2) de la rangée Rₙ₋₁ de l'empilement montée en dessous de ladite rangée Rₙ.

Une fois toutes les rangées du type «série » connectées les unes avec les autres, seules les rangées disposées aux extrémités supérieure et inférieure de l'empilement vertical possèdent des bornes électriques non connectées. L'énergie électrique générée par l'empilement de rangées du type «série» du faisceau d'échange de chaleur est prélevée par l'intermédiaires desdites bornes électriques non connectées.

Dans les exemples précédents, il a été décrit une jonction thermoélectrique entre deux intercalaires froids 16. Il va de soi qu'une jonction thermoélectrique pourrait également se créer entre deux intercalaires chauds 15.

Selon une autre forme de réalisation non représentée, chaque tube de circulation de fluide est coudé et se présente sous la forme d'un U. Selon cette alternative, les gaz chauds sont introduits et évacués de l'échangeur de chaleur par des tubulures de gaz chauds formées dans une première boîte collectrice disposée à une première extrémité de l'échangeur de chaleur, le fluide caloporteur étant introduit et évacué de l'échangeur par des tubulures formées dans une deuxième boîte collectrice disposée à une deuxième extrémité de l'échangeur de chaleur, opposée à la première extrémité par laquelle circulent les gaz chauds. Autrement dit, les gaz chauds sont introduits et évacués par une extrémité du faisceau d'échange de chaleur tandis que le fluide de refroidissement est introduit et évacué par l'extrémité opposée. Une telle configuration de l'échangeur de chaleur permet avantageusement de dissocier la circulation des fluides chauds de la circulation des fluides froids, une extrémité du faisceau d'échange de chaleur étant réservée à la circulation des fluides chauds et une autre à la circulation des fluides froids.

Des tubes métalliques ont été présentés dans les exemples de réalisation précédents. Cependant, il va de soi que les tubes pourraient être réalisés dans d'autres matières afin de permettre une conduction thermique de la chaleur des fluides circulant dans les tubes.

## Revendications

1. Dispositif de génération d'énergie électrique par conversion d'énergie calorifique en énergie électrique, comprenant :
- une première conduite de circulation d'un fluide chaud (5), le fluide chaud ayant une température T1 ;
- une deuxième conduite de circulation d'un fluide froid (6), le fluide froid ayant une température T2 qui est inférieure à la température T1 du fluide chaud ; et
- un élément thermoélectrique (10, 10'), ayant au moins deux faces (10A, 10B), agencé pour générer un courant électrique entre ses faces (10A, 10B) lorsqu'elles sont à des températures différentes,
- des moyens de conduction thermique (15, 16) se présentant sous la forme d'un premier intercalaire chaud de conduction thermique (15), par exemple une plaque métallique, relié à la conduite de fluide chaud (5), et d'un deuxième intercalaire froid de conduction thermique (16), par exemple une plaque métallique, relié à la conduite de fluide froid (6), les intercalaires chaud et froid (15, 16) étant reliés à deux faces différentes (10A, 10B) de l'élément thermoélectrique (10, 10') et chaque conduite de fluide (5, 6) traversant les deux intercalaires (15, 16).

2. Dispositif selon la revendication 1, dans lequel les moyens de conduction thermique (15, 16) sont agencés pour former, avec l'élément thermoélectrique (10, 10'), une pile électrique dont lesdits moyens de conduction thermique (15, 16) sont les bornes.

3. Dispositif selon l'une des revendications 1 à 2, dans lequel les moyens de conduction thermique (15, 16) sont agencés pour isoler électriquement les conduites de fluides (5, 6) de l'élément thermoélectrique (10, 10').

4. Dispositif selon l'une des revendications 1 à 3, dans lequel les moyens de conduction thermique (15, 16) sont agencés pour assurer le maintien en position des conduites de fluides (5, 6).

5. Dispositif selon l'une quelconque des revendications 1 à 4, dans lequel chaque intercalaire (15, 16) comporte un orifice d'isolation thermique (151, 161) et un orifice de conduction thermique (152, 162).

6. Faisceau d'échange de chaleur (3) d'un échangeur de chaleur (1) de véhicule automobile destiné à refroidir un fluide à refroidir, ledit fluide à refroidir circulant dans au moins une conduite de fluide à refroidir, ledit fluide à refroidir étant refroidi par un fluide caloporteur, de température inférieure à celle du fluide à refroidir, ledit fluide caloporteur circulant dans au moins une conduite de fluide caloporteur, ledit faisceau (3) comprenant un dispositif de génération d'énergie électrique selon l'une des revendications 1 à 5, la conduite de fluide à refroidir formant la conduite de fluide chaud (5) et la conduite de fluide caloporteur formant la conduite de fluide froid (6).

7. Faisceau selon la revendication 6, comprenant une pluralité de conduites de fluide à refroidir (5) et une pluralité de conduites de fluide caloporteur (6), dans lequel les conduites de fluide à refroidir (5) sont alternées spatialement avec les conduites de fluide caloporteur (6).

8. Faisceau selon la revendication 7, dans lequel la pluralité de conduites de fluide caloporteur (6) est maintenue en position par une pluralité d'intercalaires froids (16) et la pluralité de conduites de fluide à refroidir (5) est maintenue en position par une pluralité d'intercalaires chauds (15), les intercalaires froids (16) étant alternés spatialement avec les intercalaires chauds (15).

9. Faisceau selon la revendication 8, dans lequel les conduites de fluide caloporteur (6) et les conduites de fluide à refroidir (5) sont parallèles et coplanaires et forment, avec les intercalaires chauds et froids (15, 16), une rangée (R1, R2) du faisceau d'échange de chaleur (3).

10. Faisceau selon l'une des revendications 8 et 9, dans lequel des éléments thermoélectriques (10) sont disposés entre les intercalaires froids (16) et les intercalaires chauds (15), chaque élément thermoélectrique (10) ayant une face en contact avec un intercalaire chaud (15) et une autre face en contact avec un intercalaire froid (16).

11. Faisceau selon la revendication 10, dans lequel des jonctions thermoélectriques sont disposées entre deux intercalaires froids successifs (16), une jonction thermoélectrique comprenant deux éléments thermoélectriques (10, 10') montés en sens inverses et séparés par un intercalaire chaud (15).

12. Faisceau selon l'une des revendications 7 à 11, dans lequel les intercalaires froids (16) sont connectés électriquement en série les uns avec les autres.

13. Faisceau selon les revendications 9 et 12, dans lequel le faisceau d'échange de chaleur (3) comprend une pluralité de rangées (R1, R2).

14. Faisceau selon la revendication 13, dans lequel les rangées (R1, R2) du faisceau d'échange de chaleur (3) sont connectées électriquement en série les unes avec les autres.

15. Faisceau selon l'une des revendications 7 à 14, dans lequel le flux de gaz chaud à refroidir est un flux de gaz d'échappement d'un moteur thermique à combustion interne du véhicule automobile.

16. Echangeur de chaleur comprenant un faisceau d'échange de chaleur selon l'une des revendications 7 à 15.

## Patentansprüche

1. Vorrichtung zur Erzeugung von elektrischer Energie durch Umwandlung von Wärmeenergie in elektrische Energie, umfassend:
- eine erste Leitung zur Zirkulation eines warmen Fluids (5), wobei das warme Fluid eine Temperatur T1 aufweist;
- eine zweite Leitung zur Zirkulation eines kalten Fluids (6), wobei das kalte Fluid eine Temperatur T2 aufweist, welche niedriger als die Temperatur T1 des warmen Fluids ist; und
- ein thermoelektrisches Element (10, 10'), das mindestens zwei Seiten (10A, 10B) aufweist und dafür ausgelegt ist, einen elektrischen Strom zwischen seinen Seiten (10A, 10B) zu erzeugen, wenn sie unterschiedliche Temperaturen aufweisen,
- Wärmeleitmittel (15, 16), welche die Form eines ersten, warmen Wärmeleitungs-Zwischenstücks (15), zum Beispiel einer Metallplatte, das mit der Leitung für das warme Fluid (5) verbunden ist, und eines zweiten, kalten Wärmeleitungs-Zwischenstücks (16), zum Beispiel einer Metallplatte, das mit der Leitung für das kalte Fluid (6) verbunden ist, aufweisen, wobei das warme und das kalte Zwischenstück (15, 16) mit zwei verschiedenen Seiten (10A, 10B) des thermoelektrischen Elements (10, 10') verbunden sind und jede Fluidleitung (5, 6) die zwei Zwischenstücke (15, 16) durchquert.

2. Vorrichtung nach Anspruch 1, wobei die Wärmeleitmittel (15, 16) dafür ausgelegt sind, mit dem thermoelektrischen Element (10, 10') eine elektrische Batterie zu bilden, von der die Wärmeleitmittel (15, 16) die Pole sind.

3. Vorrichtung nach einem der Ansprüche 1 bis 2, wobei die Wärmeleitmittel (15, 16) dafür ausgelegt sind, die Fluidleitungen (5, 6) elektrisch von dem thermoelektrischen Element (10, 10') zu isolieren.

4. Vorrichtung nach einem der Ansprüche 1 bis 3, wobei die Wärmeleitmittel (15, 16) dafür ausgelegt sind, das Halten der Fluidleitungen (5, 6) in ihrer Position sicherzustellen.

5. Vorrichtung nach einem der Ansprüche 1 bis 4, wobei jedes Zwischenstück (15, 16) eine Wärmeisolations-Öffnung (151, 161) und eine Wärmeleitungs-Öffnung (152, 162) aufweist.

6. Wärmetauschbündel (3) eines Wärmetauschers (1) eines Kraftfahrzeugs, welcher dazu bestimmt ist, ein zu kühlendes Fluid zu kühlen, wobei das zu kühlende Fluid in wenigstens einer Leitung für zu kühlendes Fluid zirkuliert, wobei das zu kühlende Fluid von einem Wärmeträgerfluid mit einer Temperatur, die niedriger als die des zu kühlenden Fluids ist, gekühlt wird, wobei das Wärmeträgerfluid in wenigstens einer Wärmeträgerfluidleitung zirkuliert, wobei das Bündel (3) eine Vorrichtung zur Erzeugung von elektrischer Energie nach einem der Ansprüche 1 bis 5 umfasst, wobei die Leitung für zu kühlendes Fluid die Leitung für das warme Fluid (5) bildet und die Wärmeträgerfluidleitung die Leitung für das kalte Fluid (6) bildet.

7. Bündel nach Anspruch 6, welches mehrere Leitungen für zu kühlendes Fluid (5) und mehrere Wärmeträgerfluidleitungen (6) umfasst, wobei die Leitungen für zu kühlendes Fluid (5) räumlich abwechselnd mit den Wärmeträgerfluidleitungen (6) angeordnet sind.

8. Bündel nach Anspruch 7, wobei die mehreren Wärmeträgerfluidleitungen (6) von mehreren kalten Zwischenstücken (16) in ihrer Position gehalten werden und die mehreren Leitungen für zu kühlendes Fluid (5) von mehreren warmen Zwischenstücken (15) in ihrer Position gehalten werden, wobei die kalten Zwischenstücke (16) räumlich abwechselnd mit den warmen Zwischenstücken (15) angeordnet sind.

9. Bündel nach Anspruch 8, wobei die Wärmeträgerfluidleitungen (6) und die Leitungen für zu kühlendes Fluid (5) parallel und koplanar sind und mit dem warmen und kalten Zwischenstücken (15, 16) eine Reihe (R1, R2) des Wärmetauschbündels (3) bilden.

10. Bündel nach einem der Ansprüche 8 und 9, wobei die thermoelektrischen Elemente (10) zwischen den kalten Zwischenstücken (16) und den warmen Zwischenstücken (15) angeordnet sind, wobei jedes thermoelektrische Element (10) eine Seite, die sich mit einem warmen Zwischenstück (15) in Kontakt befindet, und eine andere Seite, die sich mit einem kalten Zwischenstück (16) in Kontakt befindet, aufweist.

11. Bündel nach Anspruch 10, wobei thermoelektrische Verbindungen zwischen zwei aufeinander folgenden kalten Zwischenstücken (16) angeordnet sind, wobei eine thermoelektrische Verbindung zwei thermoelektrische Elemente (10, 10') umfasst, die in entgegengesetzten Richtungen angebracht und durch ein warmes Zwischenstück (15) getrennt sind.

12. Bündel nach einem der Ansprüche 7 bis 11, wobei die kalten Zwischenstücke (16) zueinander elektrisch in Reihe geschaltet sind.

13. Bündel nach den Ansprüchen 9 und 12, wobei das Wärmetauschbündel (3) mehrere Reihen (R1, R2) umfasst.

14. Bündel nach Anspruch 13, wobei die Reihen (R1, R2) des Wärmetauschbündels (3) zueinander elektrisch in Reihe geschaltet sind.

15. Bündel nach einem der Ansprüche 7 bis 14, wobei der Strom von zu kühlendem warmem Gas ein Strom von Abgas einer Brennkraftmaschine des Kraftfahrzeugs ist.

16. Wärmetauscher, welcher ein Wärmetauschbündel nach einem der Ansprüche 7 bis 15 umfasst.

## Claims

1. Device for generating electrical energy by converting thermal energy into electrical energy, that comprises:
- one circulation pipe for a hot fluid (5) which has a T1 temperature;
- another circulation pipe for a cold fluid (6), the cold fluid having a T2 temperature that is less than the T1 temperature of the hot fluid; and
- a thermoelectric element (10, 10'), with at least two surfaces (10A, 10B), arranged to generate an electric current between its two surfaces (10A, 10B) when they are at different temperatures.
- the media for thermal conductivity (15, 16) are presented in the form of a first heat separator for thermal conductivity (15), a metal plate for example, connected to the hot fluid pipe (5), and another cold separator for thermal conductivity (16), such as a metal plate, connected to the cold fluid pipe (6). The hot and cold separators (15, 16) are thus connected to different surfaces (10A, 10B) of the thermoelectric element (10, 10') and each fluid pipe (5, 6) crosses both the separators (15, 16).

2. The device according to claim 1, in which the media for thermal conductivity (15, 16) are arranged to constitute along with the thermoelectric element (10, 10'), an electric battery whereof the said media of thermal conductivity (15, 16) are terminals.

3. The device according to one of the claims between 1 and 2, in which the media for thermal conductivity (15, 16) are arranged to electrically insulate the fluid pipes (5, 6) of the thermoelectric element (10, 10').

4. The device according to one of the claims between 1 and 3, in which the media for thermal conductivity (15, 16) are arranged to ensure that the position of the fluid pipes (5, 6) is maintained.

5. The device according to one of the claims between 1 and 4, in which every separator (15, 16) comprises an inlet for thermal insulation (151, 161) and an inlet for thermal conductivity (152, 162).

6. A bundle heat exchanger (3) constituting a heat exchanger (1) in an automobile vehicle designed to cool down a coolant, the said coolant circulating in at least one fluid pipe to be cooled and being cooled by a heat transfer fluid, of a temperature less than that of the coolant, the said heat transfer fluid circulating in at least one pipe of the heat transfer fluid. The said bundle (3) comprises a device for generating electrical energy in accordance with one of the claims between 1 and 5, with the pipe of the coolant forming the hot fluid pipe (5) and the pipe of the heat transfer fluid forming the cold fluid pipe (6).

7. The bundle according to claim 6, comprising several fluid pipes to be cooled (5) and several heat transfer fluid pipes (6), in which the fluid pipes to be cooled (5) are alternated with the heat transfer fluid pipes (6).

8. The bundle according to claim 7, in which the position of the plurality of heat transfer fluid pipes (6) is maintained by several cold separators (16) and the position of the plurality of the fluid pipes to be cooled (5) is maintained by several heat separators (15), the cold separators (16) being alternated spatially with the heat separators (15).

9. The bundle according to claim 8, in which the heat transfer fluid pipes (6) and the fluid pipes to be cooled (5) are parallel and coplanar and form a row (R1, R2) of the bundle heat exchanger (3) along with the hot and cold separators (15, 16).

10. The bundle according to one of the claims between 8 and 9, in which the thermoelectric elements (10) are used between the cold separators (16) and the heat separators (15), every thermoelectric element (10) having one surface in contact with a heat separator (15) and another surface in contact with a cold separator (16).

11. The bundle according to claim 10, in which the thermoelectric junctions are used between two successive cold separators (16), a thermoelectric junction comprising two thermoelectric elements (10, 10') mounted in the other direction and separated by a heat separator (15).

12. The bundle according to one of the claims between 7 and 11, in which the cold separators (16) are electrically connected in series with each other.

13. The bundle according to one of the claims between 9 and 12, in which the bundle heat exchanger (3) comprises several the rows (R1, R2).

14. The bundle according to claim 13, in which the rows (R1, R2) of the bundle heat exchanger (3) are connected electrically in series with each other.

15. The bundle according to one of the claims between 7 and 14, in which the flow of the hot gas to be cooled is an exhaust gas flow of an internal combustion engine of the automobile vehicle.

16. A heat exchanger comprising a bundle heat exchanger in accordance with one of the claims between 7 and 15.
